(19) Europäisches Patentamt European Patent Office Office européen des brevets

(11) **EP 4 546 400 A1**

(12) **EUROPEAN PATENT APPLICATION**
published in accordance with Art. 153(4) EPC

(43) Date of publication:
**30.04.2025 Bulletin 2025/18**

(21) Application number: **23826830.4**

(22) Date of filing: **12.05.2023**

(51) International Patent Classification (IPC):
*H01L 21/52* (2006.01)    *B23K 35/14* (2006.01)
*B23K 35/26* (2006.01)    *C22C 9/00* (2006.01)
*C22C 13/00* (2006.01)    *C22C 13/02* (2006.01)
*C22C 27/04* (2006.01)    *H01L 23/373* (2006.01)
*H01L 25/07* (2006.01)    *H01L 25/18* (2023.01)

(52) Cooperative Patent Classification (CPC):
**B23K 35/0205; B23K 35/26; C22C 9/00;
C22C 13/00; C22C 13/02; C22C 27/04;
H01L 21/52; H01L 23/373; H01L 25/07; H01L 25/18**

(86) International application number:
**PCT/JP2023/017824**

(87) International publication number:
**WO 2023/248642 (28.12.2023 Gazette 2023/52)**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**KH MA MD TN**

(30) Priority: **22.06.2022 JP 2022100357**

(71) Applicant: **Senju Metal Industry Co., Ltd.
Tokyo 120-8555 (JP)**

(72) Inventor: **KAMEDA, Naoto
Tokyo 120-8555 (JP)**

(74) Representative: **Hoffmann Eitle
Patent- und Rechtsanwälte PartmbB
Arabellastraße 30
81925 München (DE)**

(54) **LAMINATED BONDING MATERIAL, SEMICONDUCTOR PACKAGE, AND POWER MODULE**

(57)    A layered bonding material 10 includes a base material 11, a first solder section 12a stacked on a first surface of the base material 11, and a second solder section 12b stacked on a second surface of the base material 11. A coefficient of linear expansion of the base material 11 is 7.0 to 9.9 ppm/K, the first solder section 12a and the second solder section 12b are made of lead-free solder, the lead-free solder has a Young's modulus of 45 GPa or higher and tensile strength of 100 MPa or lower, and the thickness of the first solder section 12a is different from the thickness of the second solder section 12b.

FIG. 1

EP 4 546 400 A1

## Description

Technical Field

The present disclosure relates to a layered bonding material, a semiconductor package, and a power module.

Background Art

Recently, required characteristics of semiconductor devices have become higher. SiC, GaAs, GaN, and the like are used in addition to Si, which has been used as a material of semiconductor devices. Semiconductor devices made of these materials have excellent characteristics including a rise in an operating temperature and expanded bandgaps. The semiconductor devices are applied to power semiconductor devices such as a power transistor.

The power semiconductor devices are capable of performing a high-temperature operation. The temperature of a solder joint in a bonding section sometimes reaches high temperature equal to or higher than 200°C. Under such a high-temperature environment, there is a problem in that a strain due to a difference between CTEs (Coefficients of Thermal Expansion, also referred to as coefficients of linear expansion) of a semiconductor device and a substrate occurs in a bonding section between the semiconductor device and the substrate, a crack occurs from the strain, and, as a result, the life of the power semiconductor product is reduced.

Japanese Patent Laid-Open No. 2009-269075 describes a manufacturing method for a layered solder material including soft Pb or Pb-based alloy as a stress relaxation layer. However, since the stress relaxation layer contains Pb, the manufacturing method does not conform to environmental regulations such as RoHS (Restriction of Hazardous Substances).

Japanese Patent Laid-Open No. 2015-23183 describes a power module including a semiconductor device, a first metal layer formed with one surface bonded to the semiconductor device, an organic insulating film that is in contact with the semiconductor device and formed in an outer circumference peripheral section of the other surface of the first metal layer, a second metal layer that is in contact with the organic insulating film and is formed to be bonded to the center of the other surface of the first metal layer, and a bonding material formed to be bonded to the other surface of the first metal layer via the second metal layer.

Japanese Patent Laid-Open No. 2009-147111 describes a bonding material obtained by stacking surface layers on upper and lower surfaces of a plate-like center layer, the center layer having a melting point higher than a melting point of the surface layers. As specific examples of the center layer, a single phase of bismuth or an alloy with silver, copper, antimony, indium, tin, nickel, germanium, tellurium, or phosphorus containing bismuth as a main component is described.

Summary of Invention

It is desired to provide a layered bonding material, a semiconductor package, and a power module that can relax a strain that occurs in a bonding section, in particular, under a high-temperature environment.

A layered bonding material according to an embodiment includes: a base material; a first solder section stacked on a first surface of the base material; and a second solder section stacked on a second surface of the base material. A coefficient of linear expansion of the base material is 7.0 to 9.9 ppm/K, the first solder section and the second solder section are made of lead-free solder, the lead-free solder has a Young's modulus of 45 GPa or higher and tensile strength of 100 MPa or lower, and a thickness of the first solder section is different from a thickness of the second solder section.

Brief Description of Drawings

[Figure 1] Figure 1 is a longitudinal sectional view showing a schematic configuration of a layered bonding material according to an embodiment.

[Figure 2] Figure 2 is a longitudinal sectional view showing a schematic configuration of a semiconductor package according to the embodiment.

[Figure 3] Figure 3 is a table showing the configuration of a bonding member used in a cooling and heating cycle test and a test result (a crack growth ratio).

[Figure 4] Figure 4 is a table showing the configuration of a bonding member used in a cooling and heating cycle test and a test result (a crack growth ratio).

[Figure 5] Figure 5 is a table showing the configuration of a bonding member used in a cooling and heating cycle test and a test result (a crack growth ratio).

[Figure 6] Figure 6 is a diagram showing the configuration of a structure used in an analysis of a shearing strain of a solder bonding section.

Description of Embodiment

As a result of, while conforming to environmental regulations such as the RoHS, repeating intensive studies in order to find a technique that can relax a strain that occurs in a bonding section, the present inventors came to know that a strain that occurs in the bonding section due to a CTE difference between a semiconductor device and a substrate can be relaxed by using a material having a coefficient of thermal expansion within a predetermined range as a core material while adopting lead-free solder as solder of the bonding section. Further, the present inventors came to know that a stress relaxation effect can be improved and, as a result, the life of a product can be greatly extended compared with the related art by limiting the thickness and the material of the lead-free solder, the shape of a base material, and the like to specific ones in such a bonding section.

More specifically, the present inventors examined a mechanism of the stress relaxation effect in the bonding section as explained below.

That is, when an object in a restrained state is heated or cooled and a temperature change occurs, free expansion and contraction of the object are restrained, whereby stress (compression stress and tensile stress) occurring on the inside occurs. It is important to adopt design considering thermal stress for a restrained object exposed to an environment with a severe temperature change and the like.

Thermal stress $\sigma$ can be calculated by the Hooke's law.

[Math. 1]

$$\begin{aligned} \sigma &= E \cdot \varepsilon \\ &= E \cdot \alpha \cdot \Delta T \end{aligned}$$

(**E: Young's modulus, $\varepsilon$: thermal strain at the time of free expansion/contraction, $\alpha$: coefficient of linear expansion, $\Delta T$: temperature change**)

Here, it is seen that the Young's modulus E and the coefficient of linear expansion $\alpha$ are involved in the thermal stress $\sigma$. It is seen that the thermal strain $\varepsilon$ is smaller as the Young's modulus E is larger and a member is less easily deformed as the coefficient of linear expansion $\alpha$ is smaller.

In order to calculate a shearing strain of a solder bonding section, a strain that occurred in a bonded member and the solder bonding section when a uniform temperature change was given to a structure obtained by bonding two members having different coefficients of linear expansion with solder was analyzed by a shear-lag model [a Volkersen model] referring to Masayuki Miyazaki, Sumio Yoshioka, and Akemi Hijikata, Evaluation of Thermal Fatigue Strength of a Solder Bonding Section (1980) as a reference document.

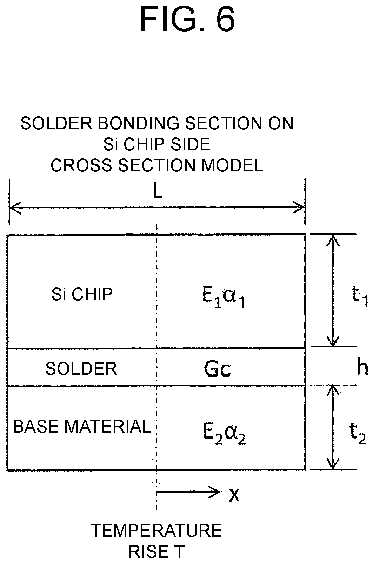

That is, it is assumed that, when a temperature change is given to a structure obtained by solder-bonding an Si chip (a member 1) and a base material (a member 2) shown in Figure 6, only uniform extensional deformation occurs in a bonded material in the longitudinal direction and only shearing deformation occurs in solder. The Si chip and the base material are elastic bodies and the solder is an elastic-perfectly plastic solid. Young's moduli (moduli of longitudinal elasticity) of the members 1 and 2 are represented as $E_1$ and $E_2$, coefficients of linear expansion of the members 1 and 2 are represented as $\alpha_1$ and $\alpha_2$ ($\alpha_2 > \alpha_1$), the thicknesses of the members 1 and 2 are represented as $t_1$ and $t_2$, the width of the members 1 and 2 is represented as w, a shear elastic modulus (G) of the solder is represented as $G_c$, and the thickness of the solder is represented as h. A formula for calculating a longitudinal direction load $P_1$ of the Si chip in a position of x from the center as the time when a uniform temperature rise T is given to this structure is represented by the following Expression (1).

[Math. 2]

$$\frac{d^2 P_1}{dx^2} - \frac{G_c}{h}\left(\frac{1}{E_2 t_2} + \frac{1}{E_1 t_1}\right) P_1 = \frac{G_c \cdot w}{h}(\alpha_2 - \alpha_1)T \qquad \cdots (1)$$

From Expression (1), when the solder is in an elastic state, strains $\varepsilon_1$, $\varepsilon_2$, and $\gamma$ that occur in the member 1 (the Si chip), the member 2 (the base material), and the solder are calculated by the following Expressions (2) and (3).

[Math. 3]

3

$$\varepsilon_i = (-1)^i \cdot \frac{(\alpha_2 - \alpha_1)}{1 + \left(\frac{E_2 t_2}{E_1 t_1}\right)^{2i-3}} \left\{ \frac{\cosh(\sqrt{A}x)}{\cosh\left(\frac{\sqrt{A}L}{2}\right)} - 1 \right\} + \alpha_i T \qquad \cdots (2)$$

Note that i=1 for the member 1 (the Si chip) and i=2 for the member 2 (the base material).
[Math. 4]

$$\gamma = \frac{(\alpha_2 - \alpha_1)T}{\sqrt{A} \cdot h} \cdot \frac{\sinh(\sqrt{A}x)}{\cosh\left(\frac{\sqrt{A}L}{2}\right)} \qquad \cdots (3)$$

$$A = \frac{G_c}{h}\left(\frac{1}{E_2 t_2} + \frac{1}{E_1 t_1}\right)$$

where,

From Expression (3), it is seen that a shearing strain that occurs in the solder is 0 in the center and increases toward an end. Therefore, a region exceeding yield stress increases from the end toward the center of the solder according to a rise of the temperature T. A boundary $x_c$ between an elastic region and a plastic region in such an elasto-plastic state is derived by the following Expression (4).
[Math. 5]

$$\sqrt{A} + \tanh(\sqrt{A}x_c)\left\{ A\left(\frac{L}{2} - x_c\right) - \frac{(\alpha_2 - \alpha_1)T}{h\gamma_y} \right\} = 0 \qquad \cdots (4)$$

Here, $\gamma_y = \tau_y / G_c$, $\tau_y$ is the yield stress of the solder. A shearing strain that occurs in the member 1 (the Si chip) and the member 2 (the base material) at this time is calculated by the following Expression (5).
[Math. 6]

$$\varepsilon_i = (-1)(-1)^i \cdot \frac{\tau_y}{E_i t_i}\left\{ \left(\frac{L}{2} - x_c\right) + k \right\} + \alpha_i T \qquad \cdots (5)$$

$$k = \frac{1}{\sqrt{A}\tanh(\sqrt{A}x_c)}\left\{ 1 - \frac{\cosh(\sqrt{A}x)}{\cosh(\sqrt{A}x_c)} \right\}$$

where,

Note that, Expression (5) holds for $(0 \leq x \leq x_c)$, and when $(x_c \leq x \leq L/2)$, $x_c = x$ and k=0.

A shearing strain that occurs in the solder is calculated by the following Expressions (6) and (7).

[Math. 7]

$$\gamma = \gamma_y \cdot \frac{\sinh(\sqrt{A}x)}{\sinh(\sqrt{A}x_c)} \qquad\qquad (0 \leq x \leq x_c) \qquad \cdots (6)$$

$$\gamma = \frac{\gamma_y A}{2}(x^2 - x_c^2) + (x - x_c)\left\{ \frac{(\alpha_2 - \alpha_1)}{h}T - \frac{\gamma_y A L}{2} \right\} + \gamma_y \qquad (x_c \leq x \leq L/2) \qquad \cdots (7)$$

From Expressions (6) and (7), a shearing strain $\gamma$ increases as the thickness h of the solder decreases. In particular, a shearing strain $\gamma_p$ obtained by elasto-plastic calculation increases substantially in proportion to 1/h.

A ratio $\gamma_p/\gamma_e$ of $\gamma_p$ to a shearing strain $\gamma_e$ obtained by elastic calculation increases as the thickness h of the solder decreases.

This indicates that a shearing strain that occurs in the solder is greatly affected by the thickness h of the solder.

As explained above, in general, the sharing strain increases and a crack growth ratio increases when the thickness of the solder decreases.

However, this time, surprisingly, in the verification of the present inventors, the crack growth ratio was successfully reduced by reducing the solder thickness on the Si chip side.

The present inventors examined a factor of the above as explained below. That is, coefficients of linear expansion [ppm/K] of used members are set as, for example, an Si chip: 3.0, a Cu base: 17.1, a base material: 7.0, and solder: 22.1. At this time, concerning an effect of the base material for the Cu base, since the difference between the coefficients of linear expansion between the Cu base and the base material (|17.1-7.0|=10.1) is larger than the difference between the coefficients of linear expansion between the Cu base and the solder (|17.1-22.1|=5.0), if the base material side is considered as a composite of the solder and the base material, it is desirable to secure a certain degree of thickness for the solder on the Cu base side in order to minimize the difference between the coefficients of linear expansion of the composite and the Cu base. This makes it easy to relax the influence of the coefficient of linear expansion of the base material. In contrast, concerning an effect of the base material for the Si chip, since the difference between the coefficients of linear expansion of the Si chip and the base material (|3.0-7.0|=4.0) is smaller than the difference between the coefficients of linear expansion of the Si chip and the solder (|3.0-22.1|=19.1), if the base material side is considered as a composite of the solder and the base material, it is desirable to secure thickness necessary for bonding of the solder on the Si chip side and reduce the thickness of the solder on the Si chip side in order to minimize the difference between the coefficients of linear expansion of the composite and the Si chip. This makes it easy to obtain the effect of the coefficient of linear expansion of the base material.

An embodiment explained below is created based on such knowledge.

A layered bonding material according to a first aspect of the embodiment includes: a base material; a first solder section stacked on a first surface of the base material; and a second solder section stacked on a second surface of the base material. A coefficient of linear expansion of the base material is 7.0 to 9.9 ppm/K, the first solder section and the second solder section are made of lead-free solder, the lead-free solder has a Young's modulus of 45 GPa or higher and tensile strength of 100 MPa or lower, and a thickness of the first solder section is different from a thickness of the second solder section.

When the present inventors performed verification with a cooling and heating cycle test, according to such an aspect, it was confirmed that, when being adopted in a bonding section of a semiconductor device and a substrate, by setting thinner one of the first solder section and the second solder section as the semiconductor device side and setting thicker one of the first solder section and the second solder section as the substrate side, it is possible to relax a strain that occurs in the bonding section, in particular, under a high-temperature environment and it is possible to achieve high reliability.

A layered bonding material according to a second aspect of the embodiment is the layered bonding material according to the first aspect, wherein

a ratio of the thickness of the first solder section and the thickness of the second solder section is 1:4 to 1:8.

A layered bonding material according to a third aspect of the embodiment is the layered bonding material according to the first or second aspect, wherein

a difference between the thickness of the first solder section and the thickness of the second solder section is 0.3 mm or more.

A layered bonding material according to a fourth aspect of the embodiment is the layered bonding material according to any one of the first to third aspects, wherein

the thickness of the first solder section is 0.05 to 0.10 mm.

A layered bonding material according to a fifth aspect of the embodiment is the layered bonding material according to any one of the first to fourth aspects, wherein

the thickness of the second solder section is 0.4 mm or more.

A layered bonding material according to a sixth aspect of the embodiment is the layered bonding material according to any one of the first to fifth aspects, wherein

the thickness of the first solder section is smaller than a thickness of the base material, and
the thickness of the second solder section is larger than the thickness of the base material.

A layered bonding material according to a seventh aspect of the embodiment is the layered bonding material according to any one of the first to sixth aspects, wherein

a coefficient of linear expansion of the base material is 7.7 to 9.9 ppm/K.

When the present inventors actually performed verification with the cooling and heating cycle test, it was confirmed that, according to such an aspect, a relaxation effect for a strain that occurs in the bonding section is higher and higher reliability can be achieved.

A layered bonding material according to an eighth aspect of the embodiment is the layered bonding material according to any one of the first to seventh aspects, wherein

a Young's modulus of the lead-free solder is 50 GPa or higher.

When the present inventors actually performed verification with the cooling and heating cycle test, it was confirmed that, according to such an aspect, the relaxation effect for a strain that occurs in the bonding section is higher and higher reliability can be achieved.

A layered bonding material according to a ninth aspect of the embodiment is the layered bonding material according to any one of the first to eighth aspects, wherein

the base material is made of any one of a Cu-W-based material, a Cu-Mo-based material, and a layered material of the Cu-W-based material and the Cu-Mo-based material.

A layered bonding material according to a tenth aspect of the embodiment is the layered bonding material according to any one of the first to ninth aspects, wherein

a Cu content of the base material is 50% or lower.

According to such an aspect, since the coefficient of linear expansion of the base material is lower, it is possible to more effectively relax a strain that occurs in the bonding section on the semiconductor device side.

A layered bonding material according to an eleventh aspect of the embodiment is the layered bonding material according to any one of the first to tenth aspects, wherein a Cu content of the base material is 15% or higher.

According to such an aspect, since thermal conductivity of the base material is further improved, a thermal strain itself that occurs in the bonding section can be further reduced.

A layered bonding material according to a twelfth aspect of the embodiment is the layered bonding material according to any one of the first to eleventh aspects, wherein

an interface between at least one of the first solder section and the second solder section and the base material is undercoated with Ni and Sn in order from a base material side.

According to such an aspect, it is possible to improve adhesion of the base material and the lead-free solder.

A layered bonding material according to a thirteenth aspect of the embodiment is the layered bonding material according to any one of the first to twelfth aspects, wherein

at least one of a ratio of the thicknesses of the base material and the first solder section and a ratio of the thicknesses of the base material and the second solder section is 2:1 to 4:1.

A layered bonding material according to a fourteenth aspect of the embodiment is the layered bonding material according to any one of the first to thirteenth aspects, wherein

a melting point of the lead-free solder is 210°C or higher.

According to such an aspect, even when the temperature of the layered bonding material reaches high temperature equal to or higher than 200°C according to a rise in an operating temperature of the semiconductor device, the lead-free solder included in the layered bonding material can be prevented from melting to cause a breakdown.

A layered bonding material according to a fifteenth aspect of the embodiment is the layered bonding material according to any one of the first to fourteenth aspects, wherein

a melting point of the lead-free solder is 230°C or higher.

A layered bonding material according to a sixteenth aspect of the embodiment is the layered bonding material according to any one of the first to fifteenth aspects, wherein

a mark allowing for distinguishing at least one of the first solder section and the second solder section from another in appearance is added to a surface of the at least one of the first solder section and the second solder section.

According to such an aspect, it is easy to distinguish the first solder section and the second solder section in appearance. When being adopted in the bonding section of the semiconductor device and the substrate, the first solder section and the second solder section are less easily mistaken to be disposed in opposite directions.

A semiconductor package according to a seventeenth aspect of the embodiment includes: a substrate; a semiconductor device disposed on the substrate; and a layered bonding material disposed between the substrate and the semiconductor device and bonding the substrate and the semiconductor device.

The layered bonding material includes: a base material; a first solder section stacked on a first surface on a semiconductor device side of the base material; and a second solder section stacked on a second surface on a substrate side of the base material, a coefficient of linear expansion of the base material is 7.0 to 9.9 ppm/K, the first solder section and the second solder section are made of lead-free solder, the lead-free solder has a Young's modulus of 45 GPa or higher and tensile strength of 100 MPa or lower, and a thickness of the first solder section is smaller than a thickness of the second solder section.

A semiconductor package according to an eighteenth aspect of the embodiment includes: a substrate; a semiconductor device disposed on the substrate; a first layered bonding material disposed between the substrate and the semiconductor device and bonding the substrate and the semiconductor device; a heat radiating section disposed on an opposite side of the semiconductor device on the substrate; and a second layered bonding material disposed between the substrate and the heat radiating section and bonding the substrate and the heat radiating section.

The first layered bonding material includes: a base material; a first solder section stacked on a first surface on a semiconductor device side of the base material; and a second solder section stacked on a second surface on a substrate side of the base material, a coefficient of linear expansion of the base material is 7.0 to 9.9 ppm/K, the first solder section and the second solder section are made of lead-free solder, the lead-free solder has a Young's modulus of 45 GPa or higher and tensile strength of 100 MPa or lower, and a thickness of the first solder section is smaller than a thickness of the second solder section.

A power module according to a nineteenth aspect of the embodiment includes: a substrate; a power semiconductor device disposed on the substrate; and a layered bonding material disposed between the substrate and the power semiconductor device and bonding the substrate and the power semiconductor device.

The layered bonding material includes: a base material; a first solder section stacked on a first surface on a power semiconductor device side of the base material; and a second solder section stacked on a second surface on a substrate side of the base material, a coefficient of linear expansion of the base material is 7.0 to 9.9 ppm/K, the first solder section and the second solder section are made of lead-free solder, the lead-free solder has a Young's modulus of 45 GPa or higher and tensile strength of 100 MPa or lower, and a thickness of the first solder section is smaller than a thickness of the second solder section.

A semiconductor package according to a twentieth aspect of the embodiment includes: a substrate; a power semiconductor device disposed on the substrate; a first layered bonding material disposed between the substrate and the power semiconductor device and bonding the substrate and the power semiconductor device; a heat radiating section disposed on an opposite side of the power semiconductor device on the substrate; and a second layered bonding material disposed between the substrate and the heat radiating section and bonding the substrate and the heat radiating section.

The first layered bonding material includes: a base material; a first solder section stacked on a first surface on a power semiconductor device side of the base material; and a second solder section stacked on a second surface on a substrate side of the base material, a coefficient of linear expansion of the base material is 7.0 to 9.9 ppm/K or less, the first solder section and the second solder section are made of lead-free solder, the lead-free solder has a Young's modulus of 45 GPa or higher and tensile strength of 100 MPa or lower, and a thickness of the first solder section is smaller than a thickness of the second solder section.

A specific example of the embodiment is explained in detail below with reference to the accompanying drawings. Note that, in the following explanation and the drawings referred to in the following explanation, the same reference numerals and signs are used for portions that can be configured the same. Redundant explanation of the portions is omitted. In the following explanation and the drawings referred to in the following explanation, concerning description of a solder composition, a numerical value in front of an element represents a mass composition (mass %) and SnBal. represents "residual Sn". For example, contents of constituent elements in a solder alloy described as "3.0Ag-0.5Cu-SnBal." are, when the entire solder alloy has 100 mass %, Ag: 3.0 mass %, Cu: 0.5 mass %, and Sn: residue. Note that, in this specification, "tensile strength" is a value measured at the room temperature by a test method specified in JIS Z2241:2011.

(Layered bonding material)

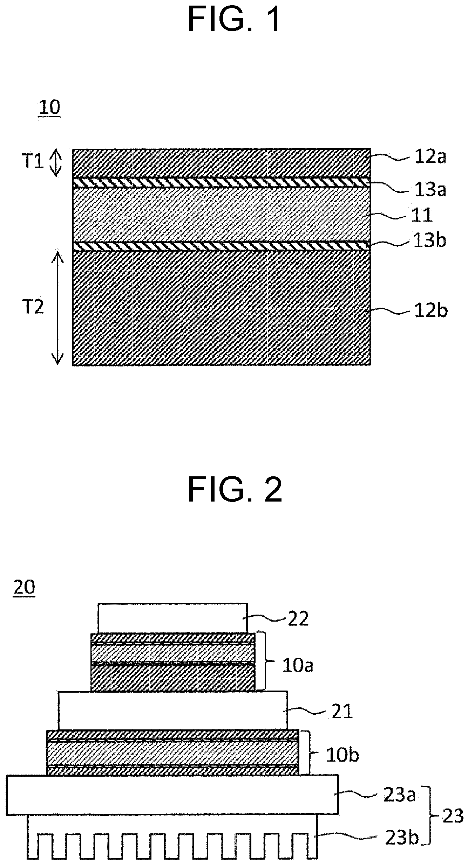

Figure 1 is a longitudinal sectional view showing a schematic configuration of a layered bonding material 10 according to the embodiment.

As shown in Figure 1, the layered bonding material 10 includes a base material 11, a first solder section 12a stacked on a first surface of the base material 11, and a second solder section 12b stacked on a second surface of the base material 11.

Of the layered bonding material 10, the base material 11 is made of a material having a coefficient of linear expansion (CTE) of 7.0 to 9.9 ppm/K. The base material 11 may have a CTE of 7.7 to 9.9 ppm/K. Specifically, for example, a Cu-W-based material or a Cu-Mo-based material is used as the base material 11. A layered material of the Cu-W-based material and the Cu-Mo-based material may be used as the base material 11. For example, a CTE of 15Cu-85W is 7.0 ppm/K. A CTE of 30Cu-70Mo is 7.7 ppm/K. A CTE of 50Cu-50Mo is 9.9 ppm/K.

Note that, in this specification, the Cu-W-based material means a material having the largest contents of Cu and W in a mass ratio among elements constituting the material. A total of the contents of Cu and W is preferably 50% or higher in a mass ratio with respect to the entire material. The Cu-W-based material may include elements other than Cu and W as impurities. The Cu-Mo-based material means a material having the largest contents of Cu and Mo in a mass ratio among elements constituting the material. A total of the contents of Cu and Mo is preferably 50% or higher in a mass ratio with respect to the entire material. The Cu-Mo-based material may include elements other than Cu and Mo as impurities.

A coefficient of linear expansion increases and a CTE difference from a semiconductor device increases when the Cu content of the base material 11 increases. Therefore, the Cu content of the base material 11 is preferably 50% or lower in a mass ratio.

Thermal conductivity is improved when the Cu content of the base material 11 increases. Therefore, the Cu content of the base material 11 is preferably 15% or higher in a mass ratio.

As shown in Figure 1, the first solder section 12a is stacked on the first surface (in an illustrated example, the upper surface) of the base material 11 and the second solder section 12b is stacked on the second surface (in the illustrated example, the lower surface) of the base material 11. Both of the first solder section 12a and the second solder section 12b are made of lead-free solder.

When the present inventors actually performed verification with a cooling and heating cycle test, it was found that, referring to Figure 2, concerning a layered bonding material 10a disposed between a substrate 21 and a semiconductor device 22, a relaxation effect for a strain that occurs in a bonding section on the substrate 11 side is higher as a Young's modulus of the lead-free solder composing the first solder section 12a and the second solder section 12b is larger and a relaxation effect for a strain that occurs in a bonding section on the semiconductor device 12 side is higher as tensile strength of the lead-free solder is smaller. Therefore, the lead-free solder composing the first solder section 12a and the second solder section 12b has a Young's modulus of 45 GPa or higher and tensile strength of 100 MPa (the middle of tensile strength 96.5 MPa of "3.4Ag-0.7Cu-3.2Bi-3.0Sb-0.025Fe-0.008Co-SnBal." and tensile strength 109.4 MPa of "3.4Ag-0.7Cu-5.0Bi-5.0Sb-0.04Ni-0.008Co-SnBal.") or lower. The lead-free solder composing the first solder section 12a and the second solder section 12b may have a Young's modulus of 50 GPa (the middle of a Young's modulus 53.8 GPa of "10.0Sb-SnBal." and a Young's modulus 48.1 GPa of "3.4Ag-0.7Cu-3.2Bi-3.0Sb-0.025Fe-0.008Co-SnBal.") or higher.

The material of the lead-free solder composing the first solder section 12a and the second solder section 12b is not particularly limited. However, for example, an Sn-based alloy, an Sn-Ag-based alloy, Sn-Cu-based alloy, an Sn-Sb-based alloy, an Sn-Ag-Cu-based alloy, an Sn-Ag-Cu-Sb-based alloy, an Sn-Ag-Cu-In-based alloy, an Sn-Ag-Cu-Bi-based alloy, an Sn-Ag-Cu-Bi-Sb-based alloy, an Sn-Bi-based alloy, an Sn-In-based alloy, or the like may be used. Note that XX-based alloy (XX are one or more types of chemical symbols) means an alloy having the largest content of XX in a mass ratio among elements constituting the alloy. Preferably, a content of XX (when XX includes two or more types of elements, a total of contents of the elements) is 50% or higher in a mass ratio with respect to the entire alloy. The XX-based alloy may include elements other than XX as impurities.

The lead-free solder composing the first solder section 12a and the lead-free solder 12b forming the second solder section 12b may have the same composition or may have different compositions each other.

As shown in Figure 1, a thickness T1 of the first solder section 12a is different from a thickness T2 of the second solder section 12b. Specifically, for example, a ratio T1:T2 of the thickness T1 of the first solder section 12a and the thickness T2 of the second solder section may be 1:4 to 1:8. The difference (T2-T1) between the thickness T1 of the first solder section and the thickness of the second solder section T2 may be 0.3 mm or more. The thickness T1 of the first solder section may be 0.05 to 0.10 mm. The thickness of the second solder section T2 may be 0.4 mm or more.

In general, when a strain that occurs in a bonded member and a solder bonding section in the case in which a uniform temperature change is given to a structure obtained by bonding, with solder, two members having different coefficients of linear expansion is analyzed by a shear-lag model [Volkersen model], it is indicated that a shearing strain increases and a crack growth ratio increases when the thickness of the solder decreases.

However, surprisingly, when the inventors actually performed verification with a cooling and heating cycle test, it was found that, referring to Figure 2, the crack growth ratio can be reduced by reducing the thickness of the first solder 12a on the semiconductor device 22 side for the layered bonding material 10a disposed between the substrate 21 and the semiconductor device 22.

The inventors examine a factor for the above as explained below. That is, when a CTE difference between the substrate 21 and the base material 11 is larger than a CTE difference between the substrate 21 and the second solder section 12b on the substrate 21 side, if a certain degree of thickness is secured as the thickness T2 of the second solder 12b on the substrate 21 side, the influence of the coefficient of linear expansion of the second solder section 12b becomes predominant (the influence of the coefficient of linear expansion of the base material 11 is easily relaxed) and an apparent CTE difference between the layered bonding material 10a and the substrate 21 is minimized. For that reason, the crack growth ratio decreases.

In contrast, when a CTE difference between the semiconductor device 22 and the base material 11 is smaller than a CTE difference between the semiconductor device 22 and the first solder section 12a on the semiconductor device 22 side, if the thickness of the first solder section 12a on the semiconductor device 22 side is reduced while thickness necessary for bonding is secured, the effect of the coefficient of linear expansion of the base material 11 is easily obtained (the influence of the coefficient of linear expansion of the first solder section 12a less easily appears) and an apparent CTE difference between the layered bonding material 10a and the semiconductor device 22 is minimized. For that reason, the crack growth ratio decreases.

A melting point of the lead-free solder composing the first solder section 12a and the second solder section 12b is preferably 210°C or higher and may be 230°C or higher, may be 240°C or higher, or may be 250°C or higher. Note that, in this specification, the melting point of the lead-free solder means a solidus temperature.

The thickness T1 of the first solder section 12a may be smaller than the thickness of the base material 11 and the thickness T2 of the second solder section 12b may be larger than the thickness of the base material 11. Specifically, for example, a ratio of the thicknesses of the base material 11 and the first solder section 12a may be 2:1 to 4:1. A ratio of the thicknesses of the second solder section 12b and the base material 11 may be 2:1 to 4:1.

Stacking of the first solder section 12a and the second solder section 12b is performed by an existing method such as electroplating, hot dipping, or cladding. The thickness of coating may be adjusted by the cladding or rolling.

As shown in Figure 1, it is preferable that an interface between at least one of the first solder section 12a and the second solder section 12b and the base material 11 is undercoated (for example, plated) with Ni and Sn in order from the base material 11 side. Since a part between the base material 11 and Sn is undercoated with Ni, diffusion of Sn to the base material 11 side can be suppressed. Since Sn is undercoated on Ni, the first solder 12a and the second solder section 12b made of the lead-free solder are easily stacked. Therefore, adhesion of the base material 11 and the first solder section 12a and the second solder section 12b made of the lead-free solder is improved. Interfaces between both of the first solder section 12a and the second solder section 12b and the base material 11 may be undercoated (for example, plated) with Ni and Sn in order from the base material 11 side.

In an illustrated example, a first ground layer 13a by undercoating is formed between the first surface of the base material 11 and the first solder section 12a made of the lead-free solder and a second ground layer 13b by undercoating is formed between the second surface of the base material 11 and the second solder section 12b made of the lead-free solder.

(Semiconductor package, power module)

Subsequently, a semiconductor package 20 according to the embodiment is explained with reference to Figure 2. Note that, in this specification, when a semiconductor device 22 included in the semiconductor package 20 is a power semiconductor device, such a semiconductor package 20 (that is, a power semiconductor package) is sometimes referred to as power module.

Figure 2 is a longitudinal sectional view showing a schematic configuration of the semiconductor package 20 according to the embodiment.

As shown in Figure 2, the semiconductor package 20 includes the substrate 21, the semiconductor device 22 disposed on the substrate 21, and a first layered bonding material 10a that bonds the substrate 21 and the semiconductor device 22.

The configuration of the first layered bonding material 10a is the same as the configuration of the layered bonding material 10 according to the embodiment explained above. Explanation of the configuration of the first layered bonding material 10a is omitted.

A type of the substrate 21 is not particularly limited. For example, a DBC (Direct Bonded Copper) substrate or a DBA (Direct Bonded Aluminum) substrate is used.

As shown in Figure 2, the semiconductor device 22 is disposed on the substrate 21 via the first layered bonding material 10a. The substrate 21 and the semiconductor device 22 are bonded by the first layered bonding material 10a. In an illustrated example, the thickness T1 of the first solder section 12a is smaller than the thickness T2 of the second solder section 12b in the first layered bonding material 10a (T1<T2) and the first solder section 12a is disposed on the semiconductor device 22 side and the second solder section 12b is disposed on the substrate 21 side.

A type of the semiconductor device 22 is not particularly limited. For example, a power semiconductor device such as a power transistor or a power diode is used. In this case, even if the temperature of the first layered bonding material 10a reaches high temperature equal to or higher than 200°C because of a rise in an operating temperature of the semiconductor device 22, if a melting point of the lead-free solder composing the first solder section 12a and the second solder section 12b is 210°C or higher in the first layered bonding material 10a, the lead-free solder can be prevented from melting to cause a breakdown.

In this embodiment, as shown in Figure 2, the semiconductor package 20 further includes a heat radiating section 23 disposed under the substrate 21 and a second layered bonding material 10b that bonds the substrate 21 and the heat radiating section 23.

The configuration of the second layered bonding material 10b is the same as the configuration of the layered bonding material 10 according to the embodiment explained above. Explanation of the configuration of the second layered bonding material 10b is omitted. However, in the second layered bonding material 10b, the thicknesses of the first solder section and the second solder section may be the same or may be different.

As shown in Figure 2, the heat radiating section 23 is disposed on the opposite side of the semiconductor device 22 on the substrate 21 via the second layered bonding material 10b. The substrate 21 and the heat radiating section 23 are bonded by the second layered bonding material 10b.

In an example shown in Figure 2, the heat radiating section 23 includes a heat radiating plate 23a and a heat radiating fin 23b closely attached and fixed to one surface (in the illustrated example, the lower surface) of the heat radiating plate 23a. The other surface (in the illustrated example, the upper surface) of the heat radiating plate 23a is closely attached and fixed to the second layered bonding material 10b. As the material of the heat radiating section 23, a material having high thermal conductivity is used. For example, CuMo or CuW is used.

When the present inventors actually performed verification with a cooling and heating cycle test explained below, it was found that, according to this embodiment explained above, it is possible to relax a strain that occurs in a bonding section, in particular, under a high-temperature environment and achieve high reliability. According to the idea of the present inventors, a coefficient of linear expansion of the base material 11 included in the first layered bonding material 10a and the second layered bonding material 10b is present in the middle between a coefficient of linear expansion of the semiconductor device 22 and a coefficient of linear expansion of the material of the substrate 21 and the heat radiating section 23 and is balanced and the first solder section 12a and the second solder section 12b made of the lead-free solder have an appropriate thickness. Therefore, it is considered possible to relax a strain that occurs in a bonding section between the semiconductor device 22 and the substrate 21 and a bonding section between the substrate 21 and the heat radiating section 23 because of a CTE difference between the semiconductor device 22 and the substrate 21 and the heat radiating section 23 under a high-temperature environment, without particularly depending on specific alloy compositions of the base material and the solder.

According to this embodiment, the base material 11 included in the first layered bonding material 10a and the second layered bonding material 10b is made of any one of a Cu-W-based material, a Cu-Mo-based material, and a layered material of the Cu-W-based material and the Cu-Mo-based material and has high thermal conductivity. Therefore, it is possible to prevent an excessive temperature rise in the bonding section, a thermal strain itself that occurs in the bonding section is reduced, and, as a result, this more advantageously acts on the extension of the life of a product of the semiconductor package 20.

According to this embodiment, a Cu content of the base material 11 included in the first layered bonding material 10a and the second layered bonding material 10b is 50% or lower. Therefore, the coefficient of linear expansion of the base material 11 is lower. It is possible to further relax a strain that occurs in the bonding section due to the CTE difference, in particular, on the semiconductor device 22 side.

According to this embodiment, a Cu content of the base material 11 included in the first layered bonding material 10a and the second layered bonding material 10b is 15% or higher. Therefore, the thermal conductivity of the base material 11 is improved and a thermal strain itself that occurs in the bonding section can be further reduced.

According to this embodiment, in the first layered bonding material 10a and the second layered bonding material 10b, the interface between at least one of the first solder section 12a and the second solder section 12b and the base material 11 is undercoated with Ni and Sn in order from the base material 11 side. Therefore, it is possible to improve adhesion of the base material 11 and the first solder section 12a and the second solder section 12b made of the lead-free solder.

According to this embodiment, in the first layered bonding material 10a and the second layered bonding material 10b, the melting point of the lead-free solder composing the first solder section 12a and the second solder section 12b is 210°C or higher. Therefore, even when the temperature of the first layered bonding material 10a and the second layered bonding material 10b reaches high temperature equal to or higher than 200°C because of a rise in an operating temperature of the semiconductor device 22, the lead-free solder included in the first layered bonding material 10a and the second layered bonding material 10b can be prevented from melting to cause a breakdown.

(Examples)

Subsequently, specific examples according to this embodiment are explained.

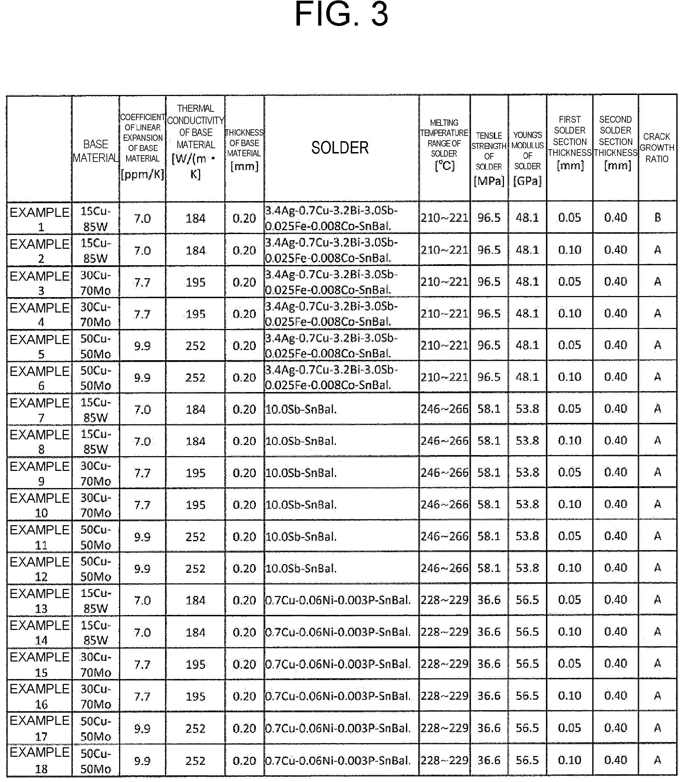

First, as shown in Figure 3 to Figure 5, the present inventors prepared bonding materials (6.5 mm square; base materials were undercoated with Ni and Sn in order from the base material sides in a solid state) in examples 1 to 18 and comparative examples 1 to 30 and created samples obtained by bonding a substrate (20 mm square; a Cu block having a thickness of 2 mm) and a semiconductor device (5.5 mm square; an Si chip having a thickness of 0.4 mm) using the bonding materials. Note that solder bonding was carried out by formic acid reduction and decompression reflow using a vacuum soldering device. In the examples 1 to 18 and the comparative examples 13 to 30, conditions are the same other than the thickness of the second solder section. That is, whereas the thickness of the second solder section is 0.40 mm and is different from the thickness of the first solder section in the examples 1 to 18, the thickness of the second solder section is the same as the thickness of the first solder section in the comparative examples 13 to 30. In the examples 1 to 18 and the comparative examples 3, 4, 7, 8, 11, and 12, conditions are the same other than the material of the solder. That is, whereas the solder in the examples 1 to 6 is "3.4Ag-0.7Cu-3.2Bi-3.0Sb-0.025Fe-0.008Co-SnBal.", the solder in the examples 7 to 12 is "10.0Sb-SnBal.", the solder in the examples 13 to 18 is "0.7Cu-0.06Ni-0.003P-SnBal.", and all the pieces of the solder have tensile strength of 100 MPa or lower, the solder in the comparative examples 1 to 12 is "3.4Ag-0.7Cu-5.0Bi-5.0Sb-0.04Ni-0.008Co-SnBal." and tensile strength of the solder exceeds 100 MPa.

Subsequently, the present inventors carried out a cooling and heating cycle test for the samples using a thermal shock chamber TSA-71L-A (manufactured by Espec Corporation) under a test condition of -40°C to +150°C (exposure times of 0.5 h). The present inventors performed SAT observation for the samples at points in time before the cooling and heating cycle test and after 1000 cycles from each of an Si chip side and a Cu base side using an ultrasonic video device FineSAT FAS200II (manufactured by Hitachi Kenki Fine Tech Co., Ltd.), calculated a defect part area ratio of a bonding section from an SAT observation image, and evaluated a change ratio (a crack growth ratio) of the defect part area ratio.

The crack growth ratio was calculated by the following expression.

Crack growth ratio (%) = {(defect part area ratio after 1000 cycles - defect part area ratio before the cooling and heating cycle test) / (100 - defect part area ratio before the cooling and heating cycle test)} $\times$ 100

A row of the "crack growth ratio" in Figure 3 to Figure 5 indicates a test result. In Figure 3 to Figure 5, in a crack growth ratio "A", the crack growth ratio on the Si chip side is lower than 13.5% and the crack growth ratio on the Cu base side is lower than 13.5%. In a crack growth ratio "B", the crack growth ratio on the Si chip side is lower than 13.5% and the crack growth ratio on the Cu base side is 13.5% or higher and lower than 51.0%. In a crack growth ratio "C", the crack growth ratio on the Si chip side is 13.5% or higher or the crack growth ratio on the Cu base side is 51.0% or higher.

As shown in Figure 3, in all of the examples 1 to 18, the crack growth ratio on the Si chip side after 1000 cycles is lower than 13.5% and the crack growth ratio on the Cu base side after 1000 cycles is lower than 51.0% (lower than 13.5% in the examples other than the example 1). It was confirmed that it is possible to effectively relax a strain that occurs in the bonding sections on both of the Cu base side and the Si chip side, in particular, under a high-temperature environment and it is possible to achieve high reliability.

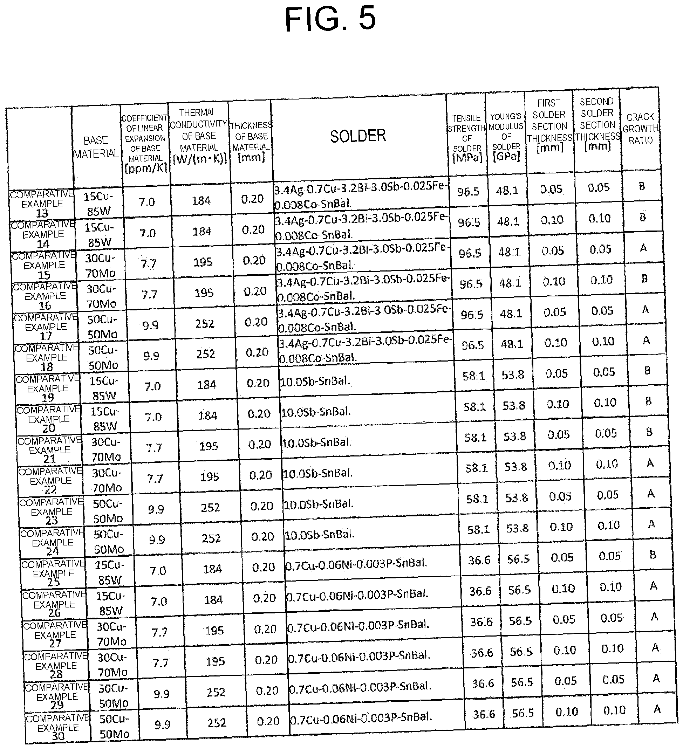

On the other hand, as shown in Figure 5, in the comparative examples 13 to 30, although the material of the solder is the same as the material in the examples 1 to 18, more crack growth ratios on the Cu base side after 1000 cycles exceed 13.5%. Note that, the examples 1 to 18 and the comparative examples 13 to 30 are different only in that, whereas the thickness of the second solder section is 0.40 mm and is different from the thickness of the first solder section in the former, the thickness of the second solder section is the same as the thickness of the first solder section in the latter.

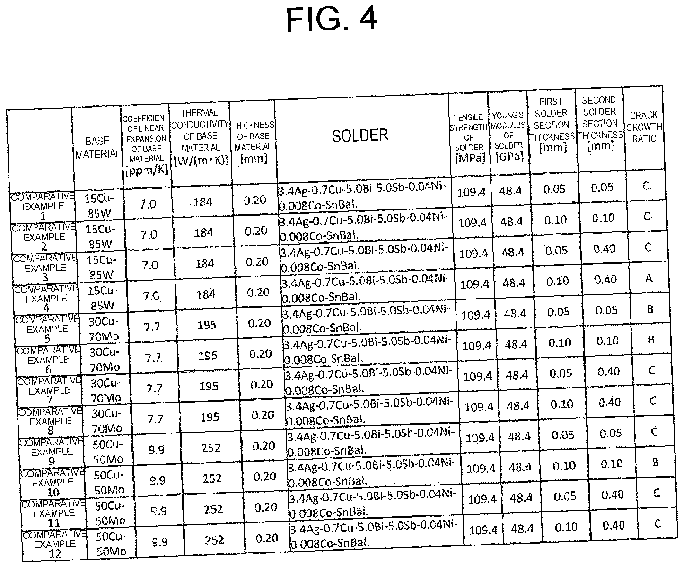

As shown in Figure 4, in the comparative examples 3, 4, 7, 8, 11, and 12, as in the examples 1 to 18, although the thickness of the second solder section is 0.40 mm and is different from the thickness of the first solder section, some crack growth ratios on the Si chip side after 1000 cycles are 13.5% or higher or some crack growth ratios on the Cu base side after 1000 cycles are 51.0% or higher. The examples 1 to 18 and the comparative examples 3, 4, 7, 8, 11, and 12 are different only in that, whereas the tensile strength of the solder is 100 MPa or lower in the former, the tensile strength of the solder exceeds 100 MPa in the latter.

It is seen from the test result explained above that, when the layered bonding material is adopted in the bonding section of the semiconductor device and the substrate, since the thickness of the first solder section on the semiconductor device side is smaller than the thickness of the second solder section on the substrate side, a Young's modulus of the lead-free solder is 45 GPa or higher, and the tensile strength of the lead-free solder is 100 MPa or lower, the relaxation effect for a strain that occurs in the bonding sections on both of the Cu base side and the Si chip side is high and high reliability can be achieved.

As shown in Figure 3, in all the examples other than the example 1, it was confirmed that the crack grow ratio on the Si chip side after 1000 cycles is lower than 13.5% and the crack growth ratio on the Cu base side after 1000 cycles is lower than 13.5% and the relaxation effect for a strain that occurs in the bonding sections on both of the Cu base side and the Si chip side is particularly high. Whereas the solder in the examples 7 to 12 is "10.0Sb-SnBal.", the solder in the examples 13 to 18 is "0.7Cu-0.06No-0.003P-SnBal.", and both the pieces of the solder has a Young's modulus of 50 GPa or higher, the solder in the example 1 is "3.4Ag-0.7Cu-3.2Bi-3.0Sb-0.025Fe-0.008Co-SnBal." and a Young's modulus of the solder is lower than 50 GPa. From this fact, it is considered preferable that a Young's modulus is 50 GPa or higher in order to further improve the relaxation effect for a strain that occurs in the bonding sections on both the Cu base side and the Si chip side and achieve higher reliability. Whereas the base material in the examples 3 and 4, 9 and 10, and 15 and 16 is "30Cu-70Mo", the base material in the examples 5 and 6, 11 and 12, and 17 and 18 is "50Cu-50Mo", and both the base materials have the coefficient of linear expansion of 7.7 to 9.9 ppm/K, the base material in the example 1 is "15Cu-85W" and the coefficient of linear expansion of the base material is lower than 7.7 ppm/K. From this fact, it is considered preferable that the coefficient of linear expansion of the base material is 7.7 to 9.9 ppm/K in order to further improve the relaxation effect for a strain that occurs in the bonding sections on both of the Cu base side and the Si chip side and achieve higher reliability.

The embodiment and the modifications are explained above by illustration. However, the scope of the present technique is not limited to the embodiment and the modifications and can be changed and modified according to a purpose within the scope described in claims. The embodiment and the modifications can be combined as appropriate in a range in which processing contents do not contradict.

## Claims

1. A layered bonding material comprising:

a base material;
a first solder section stacked on a first surface of the base material; and
a second solder section stacked on a second surface of the base material, wherein

a coefficient of linear expansion of the base material is 7.0 to 9.9 ppm/K,
the first solder section and the second solder section are made of lead-free solder,
the lead-free solder has a Young's modulus of 45 GPa or higher and tensile strength of 100 MPa or lower, and
a thickness of the first solder section is different from a thickness of the second solder section.

2. The layered bonding material according to claim 1, wherein a ratio of the thickness of the first solder section and the thickness of the second solder section is 1:4 to 1:8.

3. The layered bonding material according to claim 1 or 2, wherein a difference between the thickness of the first solder section and the thickness of the second solder section is 0.3 mm or more.

4. The layered bonding material according to claim 1 or 2, wherein the thickness of the first solder section is 0.05 to 0.10 mm.

5. The layered bonding material according to claim 1 or 2, wherein the thickness of the second solder section is 0.4 mm or more.

6. The layered bonding material according to claim 1 or 2, wherein

the thickness of the first solder section is smaller than a thickness of the base material, and
the thickness of the second solder section is larger than the thickness of the base material.

7. The layered bonding material according to claim 1 or 2, wherein a coefficient of linear expansion of the base material is 7.7 to 9.9 ppm/K.

8. The layered bonding material according to claim 1 or 2, wherein a Young's modulus of the lead-free solder is 50 GPa or higher.

9. The layered bonding material according to claim 1 or 2, wherein the base material is made of any one of a Cu-W-based material, a Cu-Mo-based material, and a layered material of the Cu-W-based material and the Cu-Mo-based material.

10. The layered bonding material according to claim 1 or 2, wherein a Cu content of the base material is 50% or lower.

11. The layered bonding material according to claim 1 or 2, wherein a Cu content of the base material is 15% or higher.

12. The layered bonding material according to claim 1 or 2, wherein an interface between at least one of the first solder section and the second solder section and the base material is undercoated with Ni and Sn in order from a base material side.

13. The layered bonding material according to claim 1 or 2, wherein at least one of a ratio of the thicknesses of the base material and the first solder section and a ratio of the thicknesses of the second solder section and the base material is 2:1 to 4:1.

14. The layered bonding material according to claim 1 or 2, wherein a melting point of the lead-free solder is 210°C or higher.

15. The layered bonding material according to claim 1 or 2, wherein a melting point of the lead-free solder is 230°C or higher.

16. The layered bonding material according to claim 1 or 2, wherein
a mark allowing for distinguishing at least one of the first solder section and the second solder section from another in appearance is added to a surface of the at least one of the first solder section and the second solder section.

17. A semiconductor package comprising:

a substrate;
a semiconductor device disposed on the substrate; and
a layered bonding material disposed between the substrate and the semiconductor device and bonding the substrate and the semiconductor device, wherein
the layered bonding material includes:

a base material;
a first solder section stacked on a first surface on a semiconductor device side of the base material; and
a second solder section stacked on a second surface on a substrate side of the base material,

a coefficient of linear expansion of the base material is 7.0 to 9.9 ppm/K,
the first solder section and the second solder section are made of lead-free solder,
the lead-free solder has a Young's modulus of 45 GPa or higher and tensile strength of 100 MPa or lower, and
a thickness of the first solder section is smaller than a thickness of the second solder section.

18. A semiconductor package comprising:

a substrate;
a semiconductor device disposed on the substrate;
a first layered bonding material disposed between the substrate and the semiconductor device and bonding the substrate and the semiconductor device;
a heat radiating section disposed on an opposite side of the semiconductor device on the substrate; and
a second layered bonding material disposed between the substrate and the heat radiating section and bonding the substrate and the heat radiating section, wherein
the first layered bonding material includes:

a base material;
a first solder section stacked on a first surface on a semiconductor device side of the base material; and
a second solder section stacked on a second surface on a substrate side of the base material,

a coefficient of linear expansion of the base material is 7.0 to 9.9 ppm/K,
the first solder section and the second solder section are made of lead-free solder,
the lead-free solder has a Young's modulus of 45 GPa or higher and tensile strength of 100 MPa or lower, and
a thickness of the first solder section is smaller than a thickness of the second solder section.

19. A power module comprising:

a substrate;
a power semiconductor device disposed on the substrate; and
a layered bonding material disposed between the substrate and the power semiconductor device and bonding the substrate and the power semiconductor device, wherein
the layered bonding material includes:

a base material;
a first solder section stacked on a first surface on a power semiconductor device side of the base material; and
a second solder section stacked on a second surface on a substrate side of the base material,

a coefficient of linear expansion of the base material is 7.0 to 9.9 ppm/K,
the first solder section and the second solder section are made of lead-free solder,
the lead-free solder has a Young's modulus of 45 GPa or higher and tensile strength of 100 MPa or lower, and
a thickness of the first solder section is smaller than a thickness of the second solder section.

20. A power module comprising:

a substrate;
a power semiconductor device disposed on the substrate;
a first layered bonding material disposed between the substrate and the power semiconductor device and bonding the substrate and the power semiconductor device;
a heat radiating section disposed on an opposite side of the power semiconductor device on the substrate; and
a second layered bonding material disposed between the substrate and the heat radiating section and bonding the substrate and the heat radiating section, wherein

the first layered bonding material includes:

a base material;
a first solder section stacked on a first surface on a power semiconductor device side of the base material; and
a second solder section stacked on a second surface on a substrate side of the base material,

a coefficient of linear expansion of the base material is 7.0 to 9.9 ppm/K or less,
the first solder section and the second solder section are made of lead-free solder,
the lead-free solder has a Young's modulus of 45 GPa or higher and tensile strength of 100 MPa or lower, and
a thickness of the first solder section is smaller than a thickness of the second solder section.

# FIG. 1

# FIG. 2

# FIG. 3

| | BASE MATERIAL | COEFFICIENT OF LINEAR EXPANSION OF BASE MATERIAL [ppm/K] | THERMAL CONDUCTIVITY OF BASE MATERIAL [W/(m·K)] | THICKNESS OF BASE MATERIAL [mm] | SOLDER | MELTING TEMPERATURE RANGE OF SOLDER [°C] | TENSILE STRENGTH OF SOLDER [MPa] | YOUNG'S MODULUS OF SOLDER [GPa] | FIRST SOLDER SECTION THICKNESS [mm] | SECOND SOLDER SECTION THICKNESS [mm] | CRACK GROWTH RATIO |
|---|---|---|---|---|---|---|---|---|---|---|---|
| EXAMPLE 1 | 15Cu-85W | 7.0 | 184 | 0.20 | 3.4Ag-0.7Cu-3.2Bi-3.0Sb-0.025Fe-0.008Co-SnBal. | 210~221 | 96.5 | 48.1 | 0.05 | 0.40 | B |
| EXAMPLE 2 | 15Cu-85W | 7.0 | 184 | 0.20 | 3.4Ag-0.7Cu-3.2Bi-3.0Sb-0.025Fe-0.008Co-SnBal. | 210~221 | 96.5 | 48.1 | 0.10 | 0.40 | A |
| EXAMPLE 3 | 30Cu-70Mo | 7.7 | 195 | 0.20 | 3.4Ag-0.7Cu-3.2Bi-3.0Sb-0.025Fe-0.008Co-SnBal. | 210~221 | 96.5 | 48.1 | 0.05 | 0.40 | A |
| EXAMPLE 4 | 30Cu-70Mo | 7.7 | 195 | 0.20 | 3.4Ag-0.7Cu-3.2Bi-3.0Sb-0.025Fe-0.008Co-SnBal. | 210~221 | 96.5 | 48.1 | 0.10 | 0.40 | A |
| EXAMPLE 5 | 50Cu-50Mo | 9.9 | 252 | 0.20 | 3.4Ag-0.7Cu-3.2Bi-3.0Sb-0.025Fe-0.008Co-SnBal. | 210~221 | 96.5 | 48.1 | 0.05 | 0.40 | A |
| EXAMPLE 6 | 50Cu-50Mo | 9.9 | 252 | 0.20 | 3.4Ag-0.7Cu-3.2Bi-3.0Sb-0.025Fe-0.008Co-SnBal. | 210~221 | 96.5 | 48.1 | 0.10 | 0.40 | A |
| EXAMPLE 7 | 15Cu-85W | 7.0 | 184 | 0.20 | 10.0Sb-SnBal. | 246~266 | 58.1 | 53.8 | 0.05 | 0.40 | A |
| EXAMPLE 8 | 15Cu-85W | 7.0 | 184 | 0.20 | 10.0Sb-SnBal. | 246~266 | 58.1 | 53.8 | 0.10 | 0.40 | A |
| EXAMPLE 9 | 30Cu-70Mo | 7.7 | 195 | 0.20 | 10.0Sb-SnBal. | 246~266 | 58.1 | 53.8 | 0.05 | 0.40 | A |
| EXAMPLE 10 | 30Cu-70Mo | 7.7 | 195 | 0.20 | 10.0Sb-SnBal. | 246~266 | 58.1 | 53.8 | 0.10 | 0.40 | A |
| EXAMPLE 11 | 50Cu-50Mo | 9.9 | 252 | 0.20 | 10.0Sb-SnBal. | 246~266 | 58.1 | 53.8 | 0.05 | 0.40 | A |
| EXAMPLE 12 | 50Cu-50Mo | 9.9 | 252 | 0.20 | 10.0Sb-SnBal. | 246~266 | 58.1 | 53.8 | 0.10 | 0.40 | A |
| EXAMPLE 13 | 15Cu-85W | 7.0 | 184 | 0.20 | 0.7Cu-0.06Ni-0.003P-SnBal. | 228~229 | 36.6 | 56.5 | 0.05 | 0.40 | A |
| EXAMPLE 14 | 15Cu-85W | 7.0 | 184 | 0.20 | 0.7Cu-0.06Ni-0.003P-SnBal. | 228~229 | 36.6 | 56.5 | 0.10 | 0.40 | A |
| EXAMPLE 15 | 30Cu-70Mo | 7.7 | 195 | 0.20 | 0.7Cu-0.06Ni-0.003P-SnBal. | 228~229 | 36.6 | 56.5 | 0.05 | 0.40 | A |
| EXAMPLE 16 | 30Cu-70Mo | 7.7 | 195 | 0.20 | 0.7Cu-0.06Ni-0.003P-SnBal. | 228~229 | 36.6 | 56.5 | 0.10 | 0.40 | A |
| EXAMPLE 17 | 50Cu-50Mo | 9.9 | 252 | 0.20 | 0.7Cu-0.06Ni-0.003P-SnBal. | 228~229 | 36.6 | 56.5 | 0.05 | 0.40 | A |
| EXAMPLE 18 | 50Cu-50Mo | 9.9 | 252 | 0.20 | 0.7Cu-0.06Ni-0.003P-SnBal. | 228~229 | 36.6 | 56.5 | 0.10 | 0.40 | A |

# FIG. 4

| | BASE MATERIAL | COEFFICIENT OF LINEAR EXPANSION OF BASE MATERIAL [ppm/K] | THERMAL CONDUCTIVITY OF BASE MATERIAL [W/(m·K)] | THICKNESS OF BASE MATERIAL [mm] | SOLDER | TENSILE STRENGTH OF SOLDER [MPa] | YOUNG'S MODULUS OF SOLDER [GPa] | FIRST SOLDER SECTION THICKNESS [mm] | SECOND SOLDER SECTION THICKNESS [mm] | CRACK GROWTH RATIO |
|---|---|---|---|---|---|---|---|---|---|---|
| COMPARATIVE EXAMPLE 1 | 15Cu-85W | 7.0 | 184 | 0.20 | 3.4Ag-0.7Cu-5.0Bi-5.0Sb-0.04Ni-0.008Co-SnBal. | 109.4 | 48.4 | 0.05 | 0.05 | C |
| COMPARATIVE EXAMPLE 2 | 15Cu-85W | 7.0 | 184 | 0.20 | 3.4Ag-0.7Cu-5.0Bi-5.0Sb-0.04Ni-0.008Co-SnBal. | 109.4 | 48.4 | 0.10 | 0.10 | C |
| COMPARATIVE EXAMPLE 3 | 15Cu-85W | 7.0 | 184 | 0.20 | 3.4Ag-0.7Cu-5.0Bi-5.0Sb-0.04Ni-0.008Co-SnBal. | 109.4 | 48.4 | 0.05 | 0.40 | C |
| COMPARATIVE EXAMPLE 4 | 15Cu-85W | 7.0 | 184 | 0.20 | 3.4Ag-0.7Cu-5.0Bi-5.0Sb-0.04Ni-0.008Co-SnBal. | 109.4 | 48.4 | 0.10 | 0.40 | A |
| COMPARATIVE EXAMPLE 5 | 30Cu-70Mo | 7.7 | 195 | 0.20 | 3.4Ag-0.7Cu-5.0Bi-5.0Sb-0.04Ni-0.008Co-SnBal. | 109.4 | 48.4 | 0.05 | 0.05 | B |
| COMPARATIVE EXAMPLE 6 | 30Cu-70Mo | 7.7 | 195 | 0.20 | 3.4Ag-0.7Cu-5.0Bi-5.0Sb-0.04Ni-0.008Co-SnBal. | 109.4 | 48.4 | 0.10 | 0.10 | B |
| COMPARATIVE EXAMPLE 7 | 30Cu-70Mo | 7.7 | 195 | 0.20 | 3.4Ag-0.7Cu-5.0Bi-5.0Sb-0.04Ni-0.008Co-SnBal. | 109.4 | 48.4 | 0.05 | 0.40 | C |
| COMPARATIVE EXAMPLE 8 | 30Cu-70Mo | 7.7 | 195 | 0.20 | 3.4Ag-0.7Cu-5.0Bi-5.0Sb-0.04Ni-0.008Co-SnBal. | 109.4 | 48.4 | 0.10 | 0.40 | C |
| COMPARATIVE EXAMPLE 9 | 50Cu-50Mo | 9.9 | 252 | 0.20 | 3.4Ag-0.7Cu-5.0Bi-5.0Sb-0.04Ni-0.008Co-SnBal. | 109.4 | 48.4 | 0.05 | 0.05 | C |
| COMPARATIVE EXAMPLE 10 | 50Cu-50Mo | 9.9 | 252 | 0.20 | 3.4Ag-0.7Cu-5.0Bi-5.0Sb-0.04Ni-0.008Co-SnBal. | 109.4 | 48.4 | 0.10 | 0.10 | B |
| COMPARATIVE EXAMPLE 11 | 50Cu-50Mo | 9.9 | 252 | 0.20 | 3.4Ag-0.7Cu-5.0Bi-5.0Sb-0.04Ni-0.008Co-SnBal. | 109.4 | 48.4 | 0.05 | 0.40 | C |
| COMPARATIVE EXAMPLE 12 | 50Cu-50Mo | 9.9 | 252 | 0.20 | 3.4Ag-0.7Cu-5.0Bi-5.0Sb-0.04Ni-0.008Co-SnBal. | 109.4 | 48.4 | 0.10 | 0.40 | C |

# FIG. 5

| | BASE MATERIAL | COEFFICIENT OF LINEAR EXPANSION OF BASE MATERIAL [ppm/K] | THERMAL CONDUCTIVITY OF BASE MATERIAL [W/(m·K)] | THICKNESS OF BASE MATERIAL [mm] | SOLDER | TENSILE STRENGTH OF SOLDER [MPa] | YOUNG'S MODULUS OF SOLDER [GPa] | FIRST SOLDER SECTION THICKNESS [mm] | SECOND SOLDER SECTION THICKNESS [mm] | CRACK GROWTH RATIO |
|---|---|---|---|---|---|---|---|---|---|---|
| COMPARATIVE EXAMPLE 13 | 15Cu-85W | 7.0 | 184 | 0.20 | 3.4Ag-0.7Cu-3.2Bi-3.0Sb-0.025Fe-0.008Co-SnBal. | 96.5 | 48.1 | 0.05 | 0.05 | B |
| COMPARATIVE EXAMPLE 14 | 15Cu-85W | 7.0 | 184 | 0.20 | 3.4Ag-0.7Cu-3.2Bi-3.0Sb-0.025Fe-0.008Co-SnBal. | 96.5 | 48.1 | 0.10 | 0.10 | B |
| COMPARATIVE EXAMPLE 15 | 30Cu-70Mo | 7.7 | 195 | 0.20 | 3.4Ag-0.7Cu-3.2Bi-3.0Sb-0.025Fe-0.008Co-SnBal. | 96.5 | 48.1 | 0.05 | 0.05 | A |
| COMPARATIVE EXAMPLE 16 | 30Cu-70Mo | 7.7 | 195 | 0.20 | 3.4Ag-0.7Cu-3.2Bi-3.0Sb-0.025Fe-0.008Co-SnBal. | 96.5 | 48.1 | 0.10 | 0.10 | B |
| COMPARATIVE EXAMPLE 17 | 50Cu-50Mo | 9.9 | 252 | 0.20 | 3.4Ag-0.7Cu-3.2Bi-3.0Sb-0.025Fe-0.008Co-SnBal. | 96.5 | 48.1 | 0.05 | 0.05 | A |
| COMPARATIVE EXAMPLE 18 | 50Cu-50Mo | 9.9 | 252 | 0.20 | 3.4Ag-0.7Cu-3.2Bi-3.0Sb-0.025Fe-0.008Co-SnBal. | 96.5 | 48.1 | 0.10 | 0.10 | A |
| COMPARATIVE EXAMPLE 19 | 15Cu-85W | 7.0 | 184 | 0.20 | 10.0Sb-SnBal. | 58.1 | 53.8 | 0.05 | 0.05 | B |
| COMPARATIVE EXAMPLE 20 | 15Cu-85W | 7.0 | 184 | 0.20 | 10.0Sb-SnBal. | 58.1 | 53.8 | 0.10 | 0.10 | B |
| COMPARATIVE EXAMPLE 21 | 30Cu-70Mo | 7.7 | 195 | 0.20 | 10.0Sb-SnBal. | 58.1 | 53.8 | 0.05 | 0.05 | B |
| COMPARATIVE EXAMPLE 22 | 30Cu-70Mo | 7.7 | 195 | 0.20 | 10.0Sb-SnBal. | 58.1 | 53.8 | 0.10 | 0.10 | A |
| COMPARATIVE EXAMPLE 23 | 50Cu-50Mo | 9.9 | 252 | 0.20 | 10.0Sb-SnBal. | 58.1 | 53.8 | 0.05 | 0.05 | A |
| COMPARATIVE EXAMPLE 24 | 50Cu-50Mo | 9.9 | 252 | 0.20 | 10.0Sb-SnBal. | 58.1 | 53.8 | 0.10 | 0.10 | A |
| COMPARATIVE EXAMPLE 25 | 15Cu-85W | 7.0 | 184 | 0.20 | 0.7Cu-0.06Ni-0.003P-SnBal. | 36.6 | 56.5 | 0.05 | 0.05 | B |
| COMPARATIVE EXAMPLE 26 | 15Cu-85W | 7.0 | 184 | 0.20 | 0.7Cu-0.06Ni-0.003P-SnBal. | 36.6 | 56.5 | 0.10 | 0.10 | A |
| COMPARATIVE EXAMPLE 27 | 30Cu-70Mo | 7.7 | 195 | 0.20 | 0.7Cu-0.06Ni-0.003P-SnBal. | 36.6 | 56.5 | 0.05 | 0.05 | A |
| COMPARATIVE EXAMPLE 28 | 30Cu-70Mo | 7.7 | 195 | 0.20 | 0.7Cu-0.06Ni-0.003P-SnBal. | 36.6 | 56.5 | 0.10 | 0.10 | A |
| COMPARATIVE EXAMPLE 29 | 50Cu-50Mo | 9.9 | 252 | 0.20 | 0.7Cu-0.06Ni-0.003P-SnBal. | 36.6 | 56.5 | 0.05 | 0.05 | A |
| COMPARATIVE EXAMPLE 30 | 50Cu-50Mo | 9.9 | 252 | 0.20 | 0.7Cu-0.06Ni-0.003P-SnBal. | 36.6 | 56.5 | 0.10 | 0.10 | A |

# FIG. 6

SOLDER BONDING SECTION ON
Si CHIP SIDE
CROSS SECTION MODEL

## INTERNATIONAL SEARCH REPORT

| International application No. |
| --- |
| **PCT/JP2023/017824** |

**A.    CLASSIFICATION OF SUBJECT MATTER**

*H01L 21/52*(2006.01)i; *B23K 35/14*(2006.01)i; *B23K 35/26*(2006.01)i; *C22C 9/00*(2006.01)i; *C22C 13/00*(2006.01)i; *C22C 13/02*(2006.01)i; *C22C 27/04*(2006.01)i; *H01L 23/373*(2006.01)i; *H01L 25/07*(2006.01)i; *H01L 25/18*(2023.01)i
FI:    H01L21/52 E; B23K35/14 A; B23K35/26 310A; C22C9/00; C22C13/00; C22C13/02; C22C27/04 101; C22C27/04 102; H01L21/52 B; H01L23/36 M; H01L25/04 C

According to International Patent Classification (IPC) or to both national classification and IPC

**B.    FIELDS SEARCHED**

Minimum documentation searched (classification system followed by classification symbols)

H01L21/52; B23K35/14; B23K35/24-35/32; C22C9/00; C22C13/00-13/02; C22C27/04; H01L21/58; H01L23/12-23/15; H01L23/34-23/40; H01L25/00-25/18

Documentation searched other than minimum documentation to the extent that such documents are included in the fields searched

Published examined utility model applications of Japan 1922-1996
Published unexamined utility model applications of Japan 1971-2023
Registered utility model specifications of Japan 1996-2023
Published registered utility model applications of Japan 1994-2023

Electronic data base consulted during the international search (name of data base and, where practicable, search terms used)

**C.    DOCUMENTS CONSIDERED TO BE RELEVANT**

| Category* | Citation of document, with indication, where appropriate, of the relevant passages | Relevant to claim No. |
| --- | --- | --- |
| A | WO 2021/193420 A1 (SENJU METAL INDUSTRY CO) 30 September 2021 (2021-09-30) | 1-20 |
| A | JP 7-221235 A (SANKEN ELECTRIC CO LTD) 18 August 1995 (1995-08-18) | 1-20 |
| A | JP 4-192341 A (HITACHI LTD) 10 July 1992 (1992-07-10) | 1-20 |
| A | JP 2005-244166 A (DENSO CORP) 08 September 2005 (2005-09-08) | 1-20 |
| A | JP 2018-190863 A (PANASONIC IP MAN CORP) 29 November 2018 (2018-11-29) | 1-20 |
| A | US 2016/0113107 A1 (DELTA ELECTRONICS, INC.) 21 April 2016 (2016-04-21) | 1-20 |
| A | JP 2006-140039 A (HITACHI CABLE LTD) 01 June 2006 (2006-06-01) | 1-20 |

☐ Further documents are listed in the continuation of Box C.        ☑ See patent family annex.

| * | Special categories of cited documents: |
| --- | --- |
| "A" | document defining the general state of the art which is not considered to be of particular relevance |
| "E" | earlier application or patent but published on or after the international filing date |
| "L" | document which may throw doubts on priority claim(s) or which is cited to establish the publication date of another citation or other special reason (as specified) |
| "O" | document referring to an oral disclosure, use, exhibition or other means |
| "P" | document published prior to the international filing date but later than the priority date claimed |

| | |
| --- | --- |
| "T" | later document published after the international filing date or priority date and not in conflict with the application but cited to understand the principle or theory underlying the invention |
| "X" | document of particular relevance; the claimed invention cannot be considered novel or cannot be considered to involve an inventive step when the document is taken alone |
| "Y" | document of particular relevance; the claimed invention cannot be considered to involve an inventive step when the document is combined with one or more other such documents, such combination being obvious to a person skilled in the art |
| "&" | document member of the same patent family |

| Date of the actual completion of the international search | Date of mailing of the international search report |
| --- | --- |
| **20 July 2023** | **01 August 2023** |

| Name and mailing address of the ISA/JP | Authorized officer |
| --- | --- |
| **Japan Patent Office (ISA/JP)**<br>**3-4-3 Kasumigaseki, Chiyoda-ku, Tokyo 100-8915**<br>**Japan** | |
| | Telephone No. |

Form PCT/ISA/210 (second sheet) (January 2015)

### INTERNATIONAL SEARCH REPORT
Information on patent family members

| Patent document cited in search report | | | Publication date (day/month/year) | Patent family member(s) | | | Publication date (day/month/year) |
|---|---|---|---|---|---|---|---|
| WO | 2021/193420 | A1 | 30 September 2021 | JP | 2021-150559 | A | |
| | | | | US | 2023/0039027 | A1 | |
| | | | | EP | 4071257 | A1 | |
| | | | | KR | 10-2022-0123723 | A | |
| | | | | CN | 115362272 | A | |
| | | | | TW | 202200365 | A | |
| JP | 7-221235 | A | 18 August 1995 | (Family: none) | | | |
| JP | 4-192341 | A | 10 July 1992 | (Family: none) | | | |
| JP | 2005-244166 | A | 08 September 2005 | US | 2005/0167802 | A1 | |
| | | | | DE | 102005002767 | A1 | |
| | | | | CN | 1649098 | A | |
| JP | 2018-190863 | A | 29 November 2018 | US | 2018/0331013 | A1 | |
| | | | | CN | 108857133 | A | |
| US | 2016/0113107 | A1 | 21 April 2016 | CN | 105575924 | A | |
| | | | | TW | 201614783 | A | |
| JP | 2006-140039 | A | 01 June 2006 | (Family: none) | | | |

Form PCT/ISA/210 (patent family annex) (January 2015)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2009269075 A
- JP 2015023183 A
- JP 2009147111 A

**Non-patent literature cited in the description**

- **MASAYUKI MIYAZAKI** ; **SUMIO YOSHIOKA** ; **AKEMI HIJIKATA**. *Evaluation of Thermal Fatigue Strength of a Solder Bonding Section*, 1980